# EUROPEAN PATENT SPECIFICATION

(11) **EP 1 872 410 B1**
(45) Date of publication and mention of the grant of the patent: **18.05.2011**
(21) Application number: 06723827.9
(22) Date of filing: 29.03.2006
(51) Int. Cl.: H01L 29/786, H01L 21/336

(54) **A method of making a semiconductor device having an arched structure strained semiconductor layer**
Verfahren zur Herstellung eines Halbleiterbauelements mit einer verspannten Halbleiterschicht mit Bogenstruktur
Procédé de fabrication de dispositifs a semi-conducteurs comportant une couche semi-conductrice contrainte a structure en arche

(30) Priority: 30.03.2005 US 93645
(43) Date of publication of application: 02.01.2008
(73) Proprietor: PAUL SCHERRER INSTITUT, 5232 Villigen PSI (CH); Garching Innovations GmbH, 80539 München (DE)
(72) Inventor: NGUYEN, Bich-Yen, Austin, TX 78733 (US); THOMAS, Shawn, G., Gilbert, Arizona 85296 (US); CERGEL, Lubomir, CH-1209 Geneve (CH); SADAKA, Mariam, G., Austin, TX 78738 (US); THEAN, Voon-Yew, Austin, Texas 78750 (US); WENNEKERS, Peter, 13505 Berlin (DE); WHITE, Ted, R., Austin, TX 78731 (US); WILD, Andreas, A., F-38000 Grenoble (FR); GRUETZMACHER, Detlev, 79787 Lauchringen (DE); SCHMIDT, Oliver, G., 70193 Stuttgart (DE)
(74) Representative: Kley, Hansjörg
(86) International application number: PCT/EP2006/002858
(87) International publication number: WO 2006/103055

(56) References cited:
- US-A1- 2005 062 080
- US-B1- 6 835 618
- ASHBURN P: "Materials and technology issues for SiGe heterojunction bipolar transistors" MATERIALS SCIENCE IN SEMICONDUCTOR PROCESSING, ELSEVIER SCIENCE PUBLISHERS B.V., BARKING, UK, vol. 4, no. 6, December 2001 (2001-12), pages 521-527, XP004345735 ISSN: 1369-8001
- ZYTKIEWICZ Z R ET AL: "Strain in GaAs layers grown by liquid phase epitaxial lateral overgrowth" JOURNAL OF APPLIED PHYSICS, AMERICAN INSTITUTE OF PHYSICS. NEW YORK, US, vol. 86, no. 4, 15 August 1999 (1999-08-15), pages 1965-1969, XP012048429 ISSN: 0021-8979
- VESCAN L: "Strained SiGe/Si quantum well dots and wires selectively grown by LPCVD and their optical properties" THIN SOLID FILMS, ELSEVIER-SEQUOIA S.A. LAUSANNE, CH, vol. 294, no. 1-2, 15 February 1997 (1997-02-15), pages 284-290, XP004225625 ISSN: 0040-6090
- PRINZ V Y: "A new concept in fabricating building blocks for nanoelectronic and nanomechanic devices" MICROELECTRONIC ENGINEERING, ELSEVIER PUBLISHERS BV., AMSTERDAM, NL, vol. 69, no. 2-4, September 2003 (2003-09), pages 466-475, XP004456697 ISSN: 0167-9317
- MONFRAY S ET AL: "50NM - GATE ALL AROUND (GAA) - SILICON ON NOTHING (SON) - DEVICES: A SIMPLE WAY TO CO-INTEGRATION OF GAA TRANSISTORS WITHIN BULK MOSFET PROCESS" 2002 SYMPOSIUM ON VLSI TECHNOLOGY. DIGEST OF TECHNICAL PAPERS. HONOLULU, JUNE 11 - 13, 2002, SYMPOSIUM ON VLSI TECHNOLOGY, NEW YORK, NY : IEEE, US, 11 June 2002 (2002-06-11), pages 108-109, XP001109840 ISBN: 0-7803-7312-X
- PATENT ABSTRACTS OF JAPAN vol. 2000, no. 22, 9 March 2001 (2001-03-09) -& JP 2001 144276 A (TOSHIBA CORP), 25 May 2001 (2001-05-25) -& US 2006/131651 A1 (SATO TSUTOMU ET AL) 22 June 2006 (2006-06-22)

## Description

### BACKGROUND

The present disclosure relates to semiconductor device structures and more particularly, to a strained semiconductor device having an arch structure and method of making the same.

### Related Art

In the art, there is a concept known as silicon-on-nothing which refers to having a cavity under a Si channel. However, the devices described with respect to the silicon-on-nothing concept reflect bulk CMOS type devices. The US patent application 2005/0062080 A1 is representing such a semiconductor device having a thin-film Si layer with a source/drain formed therein. The thin-film Si layer is curved from a region directly below a gate electrode towards a region near the source/drain. The curved thin-film Si layer develops strains in a channel region disposed directly below the gate electrode sandwiched by the source/drain in the thin-film Si layer, for thereby increasing a carrier mobility. A cavity is defined below the curved thin-film Si layer for reducing a parasitic capacitance due to a pn junction. In this regard, this document discloses to use an empty cavity in order to reduce parasitic capacitance only without using this structure for further advantageous purposes.

Strained Si has the potential to enhance performance of CMOS devices, that is, by increasing drive currents. However, the approaches to realizing strained Si are often complicated. Such approaches include thick graded buffer layers, condensation, wafer bonding, etc.

What is needed is an improved method and apparatus for addressing the next generation beyond silicon on nothing, that is, to be able to include strained silicon.

### BRIEF DESCRIPTION OF THE DRAWINGS

The embodiments of the present disclosure are illustrated by way of example and not limited by the accompanying figures, in which like references indicate similar elements, and in which:

Figures 1-7 illustrate device cross-sections at various process steps in the method of making a strained semiconductor device arch structure according to an embodiment of the present disclosure;

Figures 8-13 illustrate device cross-sections at various additional process steps for the fabrication of an integrated circuit device according to an embodiment of the present disclosure;

Figure 14 is a top view of a seed layer region for use in making a strained semiconductor device arch structure according to one embodiment of the present disclosure;

Figure 15 is a three-dimensional plan view of a strain inducing structure formed over the seed layer region of Figure 14 according to one embodiment of the present disclosure;

Figure 16 is a top view of an elongated seed layer region for use in making a strained semiconductor device arch structure according to another embodiment of the present disclosure;

Figure 17 is a three-dimensional plan view of a strain inducing structure formed over the elongated seed layer region of Figure 16 according to one embodiment of the present disclosure;

Figure 18 is a cross-sectional view of the strained semiconductor device arch structure according to another embodiment of the present disclosure;

Figure 19 is a cross-sectional view of the strained semiconductor device arch structure according to yet another embodiment of the present disclosure; and

Figures 20-24 illustrate device cross-sections at various process steps in the method of making an integrated circuit having a strained semiconductor device arch structure according to yet another embodiment of the present disclosure.

Skilled artisans appreciate that elements in the figures are illustrated for simplicity and clarity and have not necessarily been drawn to scale. For example, the dimensions of some of the elements in the figures may be exaggerated relative to other elements to help improve an understanding of the embodiments of the present disclosure.

### DETAILED DESCRIPTION

According to one embodiment, a method of forming a strained semiconductor device includes forming a local strain inducing structure of a first material and forming a single crystalline structure of a second material over the local strain inducing structure. The single crystalline structure is subject to mechanical strain by an arched surface of the strain inducing structure.

In one approach of the present disclosure, strained Si can be realized in a simple epitaxial process that allows the potential to realize a surround gate MOSFET structure, as well as, accurately tune the level of strain in the device. Additionally, the structure according to the embodiments of the present disclosure has the possibility to be integrated in a back-end process for potential 3D integration.

In one embodiment, a silicon substrate is covered with oxide and then etched to form openings (or holes) in the oxide to expose the underlying Si substrate. The openings serve as an initial template for locations where strain inducing Ge or SiGe alloy dots and subsequent strained induced MOSFET devices will be fabricated. Into the openings is deposited SiGe, where the Ge concentration can vary from 0 to 100%. In one embodiment, the SiGe layer is deposited by being grown in a selective manner, although formation of the SiGe layer is not limited to selective growth alone. For example, non-selective growth can be combined with chemical mechanical polishing (CMP) to achieve the same desired structure at this point in the process. The SiGe layer that is deposited into the holes can be amorphous, poly-crystalline or single crystalline. In a preferred embodiment, the SiGe is single crystalline.

A pure Ge or SiGe dot is then grown selectively such that the nucleation site for the Ge or SiGe dot is the SiGe filled hole (i.e., a point location). The amount of Ge in the SiGe underlying layer will determine the size of the Ge or SiGe dot that is subsequently grown. Dots can be grown in a dome shape or a hut shape and each shape may have desirable properties. Subsequently, the Ge or SiGe dot is overgrown by a thin Si layer which will eventually form the channel region of the final device. In this approach, the thin Si layer that is grown over the Ge or SiGe dot will have strain induced in the layer due to the underlying Ge or SiGe dot. It is this strain that will be utilized to fabricate a strained Si type field effect transistor (FET). Subsequent to the thin Si layer over the Ge or SiGe dot, the Ge or SiGe dot can be removed selectively, for example, using a peroxide/HF chemistry, to create a cavity below the grown Si channel region. The Si channel region maintains its convex shape in order to retain strain in the channel. CMOS fabrication can continue to form source/drain and gate on the resulting arch of strained Si. Additionally, the cavity where the Ge or SiGe dot was initially grown can be backfilled with a material so as to induce additional strain in the Si channel or with a material that can serve as a backgate to realize a double gate or surround gate MOSFET device.

Accordingly, the embodiments of the present disclosure provide an alternate path to realizing a strained Si MOSFET device as compared to traditional approaches such as graded buffer layers. Additionally, the level of strain in the Si channel can be adjusted more readily than traditional approaches so that devices with differing levels of strain can be achieved on the same wafer. This approach also identifies a path to realize a surround gate MOSFET for true volume control of the channel region. Additionally, the channel thickness is defined epitaxially, so atomically smooth top and bottom interfaces are achievable, which is a benefit over competing device structures such as FinFET which are defined by dry etching. Furthermore, the embodiments of the present disclosure can be implemented for applications of high performance CMOS or low power CMOS.

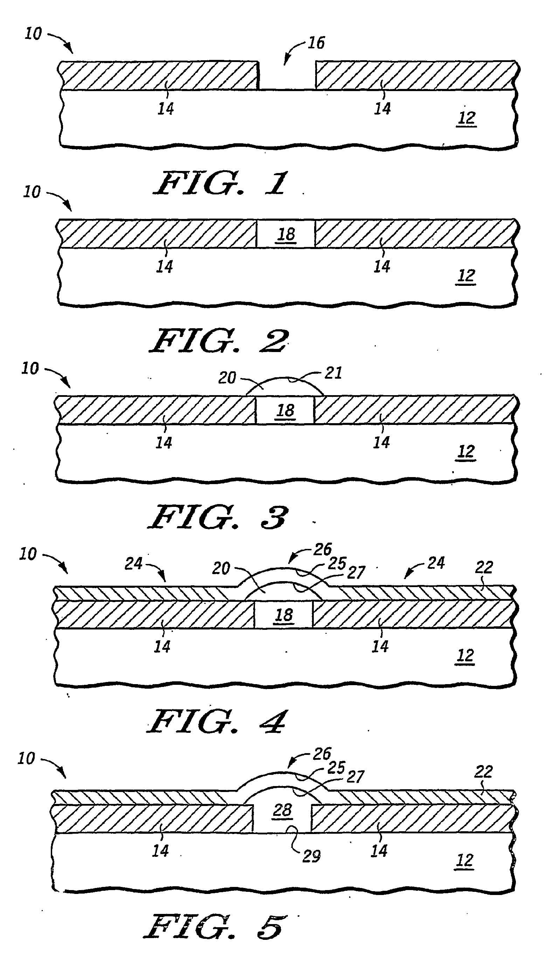

Referring now to the drawings, Figures 1-7 illustrate device cross-sections at various process steps in the method of making a strained semiconductor device arch structure according to one embodiment of the present disclosure. With reference now to Figure 1, formation of a semiconductor structure 10 begins with providing a semiconductor substrate 12 and a dielectric 14 layer overlying the semiconductor substrate 12. An opening or patterned window 16 is also provided within the dielectric layer 14 at a desired location of a strained semiconductor device arch structure yet to be formed. Window 16 exposed a portion of the underlying semiconductor substrate 12.

Substrate 12 can include a bulk semiconductor substrate, a semiconductor on insulator substrate (SOI), or any other substrate suitable for a particular strained semiconductor device arch structure application. For example, substrate 12 can include a silicon substrate and dielectric layer 14 can include an oxide. Other substrate and dielectric layer combinations are also possible. For example, substrate 12 may also include a gallium arsenide (GaAs) substrate, silicon germanium (SiGe) substrate, or other suitable semiconductor substrate.

Window 16 provides a point location within dielectric layer 14 for subsequent deposition of a seed layer 18. In Figure 2, seed layer 18 is selectively deposited inside window 16, on an exposed portion of the surface of substrate 12 within the window 16, using standard deposition techniques. Seed layer 18 can include one selected from a silicon (Si) or silicon germanium (SiGe) seed layer. For example, the silicon germanium (SiGe) seed layer can include Si₁₋ₓGeₓ. In addition, the concentration of Ge can be graded from zero percent (0%) to a few percent (%) or desired concentration. In addition, chemical mechanical polishing (CMP) can be used to smooth the top surface of seed layer 18. In one embodiment, seed layer 18 is representative of a dot when viewed from above.

In Figure 3, a strain inducing material is selectively deposited upon an upper exposed surface of seed layer 18, such that the strain inducing material overlies slightly onto an exposed surface of dielectric layer 14 to form a strain inducing structure 20. As illustrated, a top surface 21 of the strain inducing structure 20 has a particular geometry or curvature. For example, the geometry may be that of a portion of an arched surface, a portion of a spherical shape, and a portion of a cylindrical shape. In one embodiment, the material of the strain inducing structure 20 includes silicon/silicon germanium (Si/SiGe). In one embodiment, strain inducing structure 20 is representative of a dot when viewed from above.

In Figure 4, subsequent to forming the strain inducing structure 20, a semiconductor material 22 is grown overlying the dielectric layer 14 and the strain inducing structure 20, for example, using suitable techniques known in the art. The semiconductor material 22 is selected for use as a device active layer, as will be discussed further herein. In particular, the semiconductor material 22 is grown over the exposed surface of dielectric layer 14 in a region indicated by reference numeral 24 and over the exposed surface of the strain inducing structure 20 in a region indicated by reference numeral 26.

In one embodiment, the semiconductor material 22 includes amorphous silicon (Si). Accordingly, the semiconductor material 22 grown in the region indicated by reference numeral 24 (i.e., outside the region of the strain inducing structure 20) includes poly-silicon. The semiconductor material 22 in region 24 forms poly-silicon as a result of the layer being grown on a dielectric. Whereas, the semiconductor material 22 grown in the region indicated by reference numeral 26, overlying the strain inducing semiconductor structure 20, includes single crystal silicon.

In Figure 5, the strain inducing structure 20 and underlying seed layer 18 are selectively removed using standard selective etch techniques after gaining access to them via a shallow trench isolation edge (not shown). Selective removal of the strain inducing structure 20 and seed layer 18 forms a corresponding void 28. In one embodiment, the strain inducing structure 20 comprises Si/SiGe or Ge and the underlying seed layer 18 comprises Ge or SiGe. In another embodiment, the semiconductor seed material and the strain-inducing structure are each comprised of at least one of group III elements and group V elements.

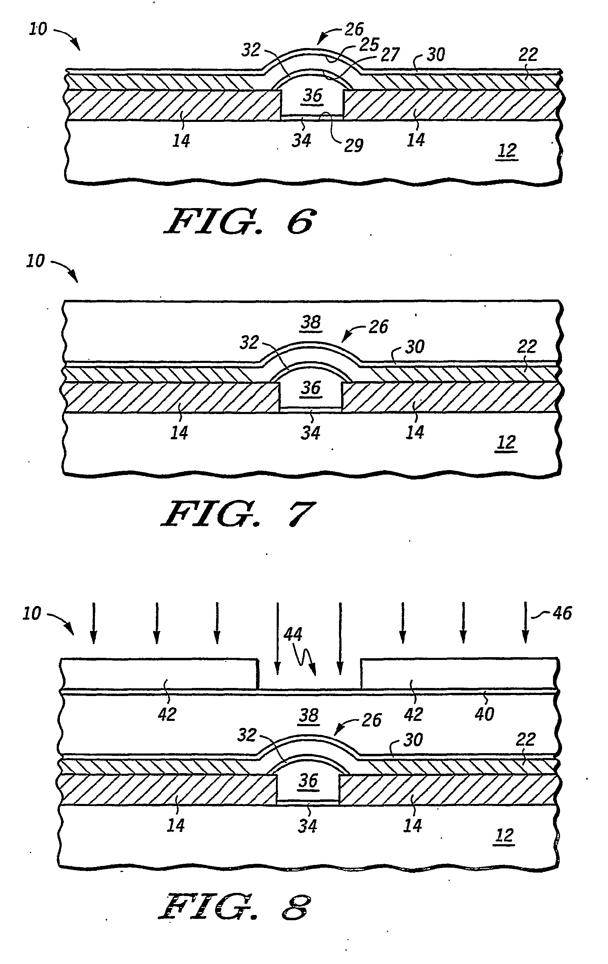

Subsequent to formation of void 28, as illustrated in Figure 6, a dielectric layer (30,32,34) is formed overlying a top surface 25 of active layer 22, underlying an arched bottom surface 27 of active layer 22, and on a bottom surface 29 of void 28 (Figure 5). In one embodiment, structure 10 is subjected to a control gate oxidation. Control gate oxidation forms an oxide 30 overlying the top surface 25 of active layer 22 in the region indicated by reference numeral 26, forms an oxide 32 underlying the arched bottom surface 27 of active layer 22 in the region indicated by reference numeral 26, and forms an oxide 34 at the bottom surface 29 of void 28, on an exposed portion of semiconductor substrate 12. In addition, the control gate oxidation also forms a modified opening of void 28 (Figure 5), now indicated by reference numeral 36 (Figure 6). Access to the void 36 is removed with completion of a shallow trench isolation filling (not shown).

Subsequent to formation of the control gate dielectric 30, the method proceeds with deposition of a control electrode material 38, as shown in Figure 7. In one embodiment, the control electrode material 38 includes polysilicon, wherein the polysilicon is conformally deposited using standard polysilicon deposition and planarization techniques.

Figures 8-13 illustrate device cross-sections at various additional process steps for the fabrication of an integrated circuit device according to an embodiment of the present disclosure. Following the control gate dielectric formation, as shown in Figure 8, a gate polysilicon patterning and implant are carried out. For example, an anti-reflective coating layer 40 is deposited overlying the control gate material 38. Anti-reflective coating layer 40 can include any suitable anti-reflective coating layer, for example, a nitride. A photo resist 42 is deposited onto the anti-reflective coating layer 40. The photo resist 42 is then patterned to form opening 44. Subsequent to forming the opening 44, a gate polysilicon implant 46 is performed according to the gate polysilicon dopant requirements of a particular strained semiconductor device application.

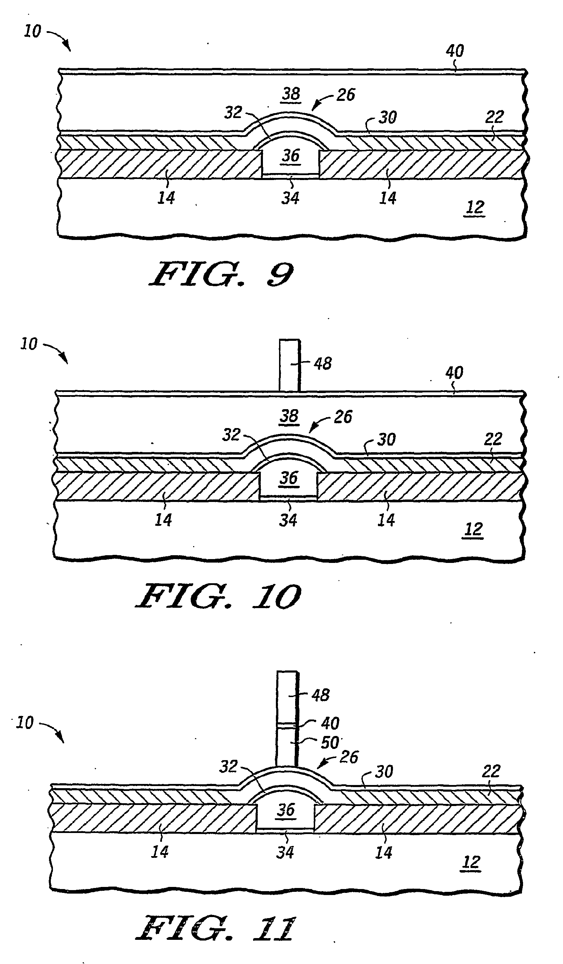

Subsequent to the gate electrode implant, the patterned photo resist 42 is removed, as shown in Figure 9. Upon removal of the photo resist 42, another photo resist 48 is deposited and patterned, according to the particular gate electrode channel length requirements for a particular strained semiconductor device application, for example, as shown in Figure 10. Subsequent to forming the patterned photo resist 48, the photo resist pattern 48 is transferred into the underlying anti-reflective coating layer 40 and the underlying control electrode material 38, for example, as shown in Figure 11.

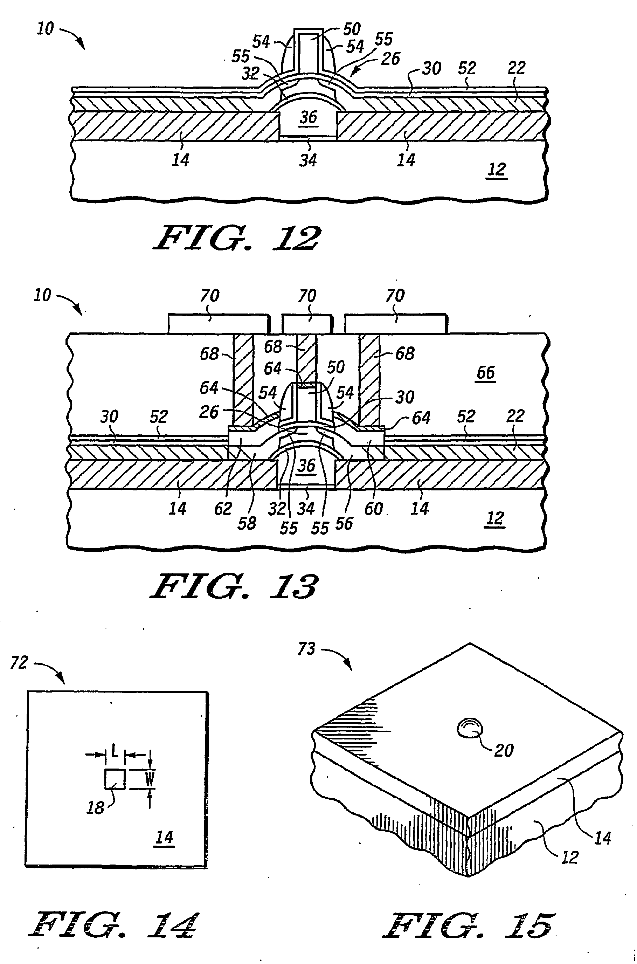

Following formation of the control electrode 50, a dielectric liner 52 is deposited, the dielectric liner for insulating, protecting, and/or passivating the corresponding underlying layers. Dielectric liner 52 includes any suitable dielectric, for example, a silicon oxide or silicon nitride. Subsequent to forming dielectric liner 52, extension implants are done for forming extension regions 53 and 55 within region 26 which corresponds to the single crystal portion of semiconductor material 22. Sidewall spacers 54 are then formed adjacent to the sidewalls of control electrode 50, with dielectric liner 52 in between the sidewall spacers and the control electrode, as shown in Figure 12.

Various additional processing steps are carried out to form the strained semiconductor device 10 as shown in Figure 13. Strained semiconductor device 10 includes source/drain regions (56,58), elevated source/drain regions (60,62), self-aligned silicided regions 64, and interlevel dielectric 66. Conductive vias 68 extend from a corresponding silicided contact region 64 to a top surface of the interlevel dielectric 66. Lastly, metallization 70 provides suitable contact pads for coupling to conductive vias 68.

Figure 14 is a top view 72 of a seed layer 18 for use in making a strained semiconductor device arch structure according to one embodiment of the present disclosure. Seed layer 18 is defined by the dimensions of opening 16 (Figure 1) in dielectric layer 14, overlying substrate 12. In the embodiment of Figure 14, the top view 72 illustrates seed layer 18 as being defined by a length (L) and width (W), wherein the length and width are approximately equal in dimension. In other words, the point location within dielectric layer 14 as shown in Figure 14 is defined by a length dimension and a width dimension, wherein the length dimension is approximately equal to the width dimension.

Figure 15 is a three-dimensional plan view 73 of a strain inducing structure 20 formed over the seed layer 18 of Figure 14 according to one embodiment of the present disclosure. As discussed earlier with respect to Figure 3, a strain inducing material is deposited upon an upper exposed surface of seed layer 18, such that the strain inducing material overlies slightly onto an exposed surface of dielectric layer 14 to form a strain inducing structure 20. As illustrated, the top surface of the strain inducing structure 20 has a particular geometry or curvature, for example, the geometry may be that of a portion of an arched surface or a portion of a spherical shape. In the embodiment of Figure 15, the strain inducing structure 20 resembles a dot.

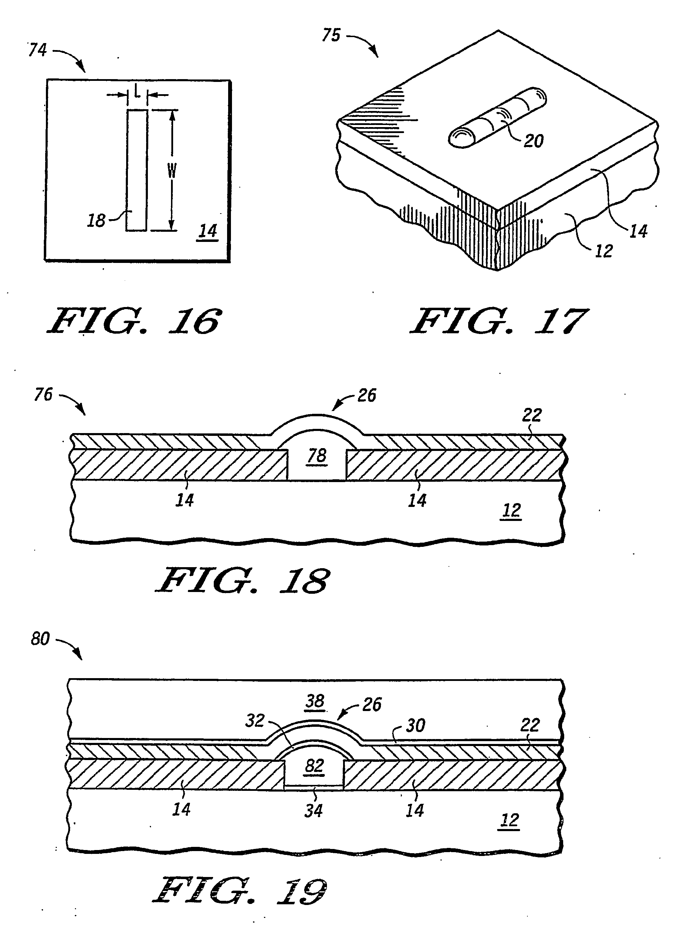

Figure 16 is a top view 74 of an elongated seed layer 18 for use in making a strained arch structure semiconductor device according to another embodiment of the present disclosure. Seed layer 18 is defined by the dimensions of opening 16 (Figure 1) in dielectric layer 14, overlying substrate 12. In the embodiment of Figure 16, the top view 74 illustrates seed layer 18 as being defined by a length (L) and width (W), wherein the length dimension is smaller than the width dimension. In other words, the point location within dielectric layer 14 as shown in Figure 16 is defined by a length dimension and a width dimension, wherein the length dimension is smaller than the width dimension.

Figure 17 is a three-dimensional plan view 75 of a strain inducing structure 20 formed over the elongated seed layer 18 of Figure 16 according to one embodiment of the present disclosure. As discussed earlier with respect to Figure 3, a strain inducing material is deposited upon an upper exposed surface of seed layer 18, such that the strain inducing material overlies slightly onto an exposed surface of dielectric layer 14 to form a strain inducing structure 20. As illustrated, a top surface of the strain inducing structure 20 has a particular geometry or curvature, for example, the geometry may be that of a portion of an arched surface or a portion of a cylindrical shape. In the embodiment of Figure 17, the strain inducing structure 20 resembles a portion of a cylinder with rounded ends.

Figure 18 is a cross-sectional view of the strained semiconductor device arch structure 76 according to another embodiment of the present disclosure. Subsequent to selective removal of the strain inducing structure 20 and underlying seed layer 18 using standard selective etch techniques as discussed earlier herein with respect to Figure 5, the corresponding void 28 (Figure 5) formed by the selective removal is refilled with another material 78 (Figure 18). The material 78 is a material selected to induce a further strain into the single crystal channel region 26 of semiconductor material layer 22. For example, material 78 can include an insulating material, such as silicon nitride, silicon oxide, or silicon oxynitride. The further strain comprises a mechanical strain. In other words, the presence of mechanical stress inducing material 78 in the void provides a greater amount of mechanical stress than was provided by the semiconductor material (20,18) that was removed (Figure 4).

Figure 19 is a cross-sectional view of the strained semiconductor device arch structure 80 according to yet another embodiment of the present disclosure. Subsequent to the control gate oxidation 30 and formation of a modified opening 36 as discussed earlier herein with respect to Figure 6, the modified opening 36 (Figure 6) is refilled with material 82. The material 82 is a material selected to induce a further strain into the single crystal channel region 26 of semiconductor material layer 22. Material 82 can be a material similar to that of material 78, as discussed with respect to Figure 18. The further strain comprises a mechanical strain.

Furthermore, refilling the modified opening 36 with material 82 can occur with the conformal deposition of a control gate electrode material 38, as shown in Figure 19, wherein material 82 and 38 are the same material. In one embodiment, the materials 38 and 82 include polysilicon deposited using any suitable standard polysilicon deposition techniques. The control gate electrode material 38 and 82 are selected to induce additional strain in the single crystal channel region 26 of semiconductor material layer 22. The further strain comprises a mechanical strain. Still further, materials 38 and 82 can be used to realize a surround gate MOSFET device, wherein the material 82 acts as a lower portion of the surround gate electrode and material 38 acts as an upper portion of the surround gate electrode. Similarly, a dual gate MOSFET device can be realized by making materials 38 and 82 electrically separate, wherein the material 82 acts as a lower control gate electrode and material 38 acts as an upper control gate electrode. Accordingly, the upper gate electrode structure includes a gate electrode of material 38 and a gate dielectic 30. Similarly, the lower gate electrode structure includes a gate electrode of material 82 and a gate dielectic 32.

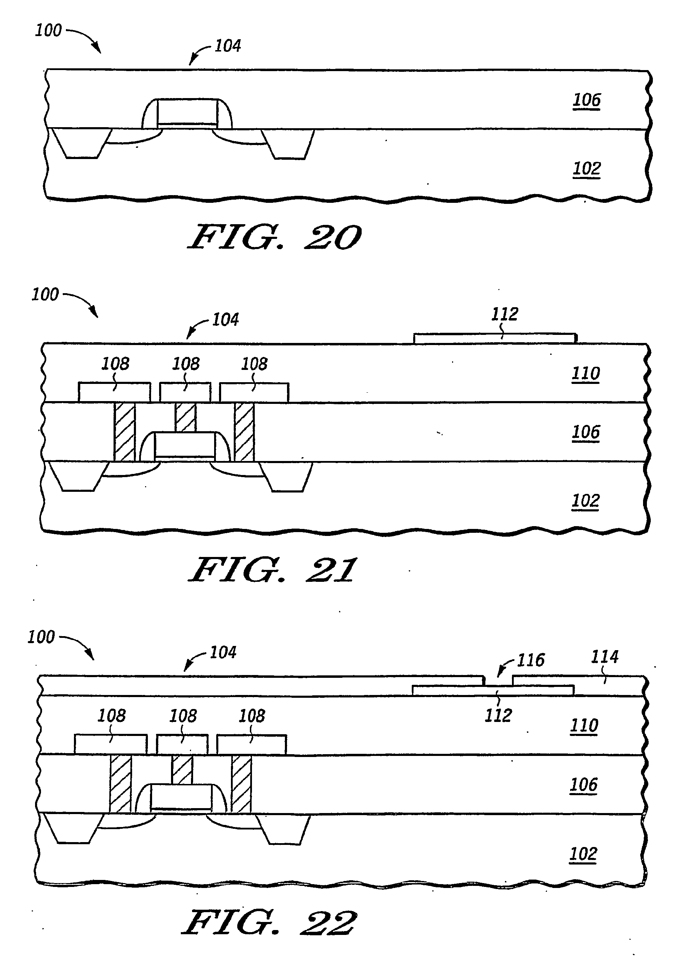

Figures 20-24 illustrate device cross-sections at various process steps in the method of making an integrated circuit 100 featuring a strained semiconductor device arch structure according to yet another embodiment of the present disclosure. As shown in Figure 20, a substrate 102 is provided. A transistor device, generally indicated by reference numeral 104 is then formed using standard processing techniques. Subsequent to formation of transistor device 104, a first interlevel dielectric layer 106 is formed using standard processing techniques. The illustration in Figure 20 is representative of a baseline CMOS/BiCMOS process.

Referring now to Figure 21, contact vias and metalizations 108 are formed, followed by formation of a second interlevel dielectric layer 110. Following formation of the second interlevel dielectric 110, a layer of semiconductor material 112 is formed on a top surface of the second interlevel dielectric 110. The layer of semiconductor material 112 can be patterned according to the particular requirements of a strained semiconductor device arch structure being fabricated. In addition, material 112 can include an amorphous or single crystal semiconductor material. In one embodiment, material 112 includes amorphous silicon.

Referring now to Figure 22, a layer of dielectric material 114 is deposited and an opening 116 formed in the dielectric material 114, over a portion of the semiconductor material 112. Opening 116 is similar to opening 16 as discussed earlier herein. In one embodiment, dielectric material 114 includes an oxide.

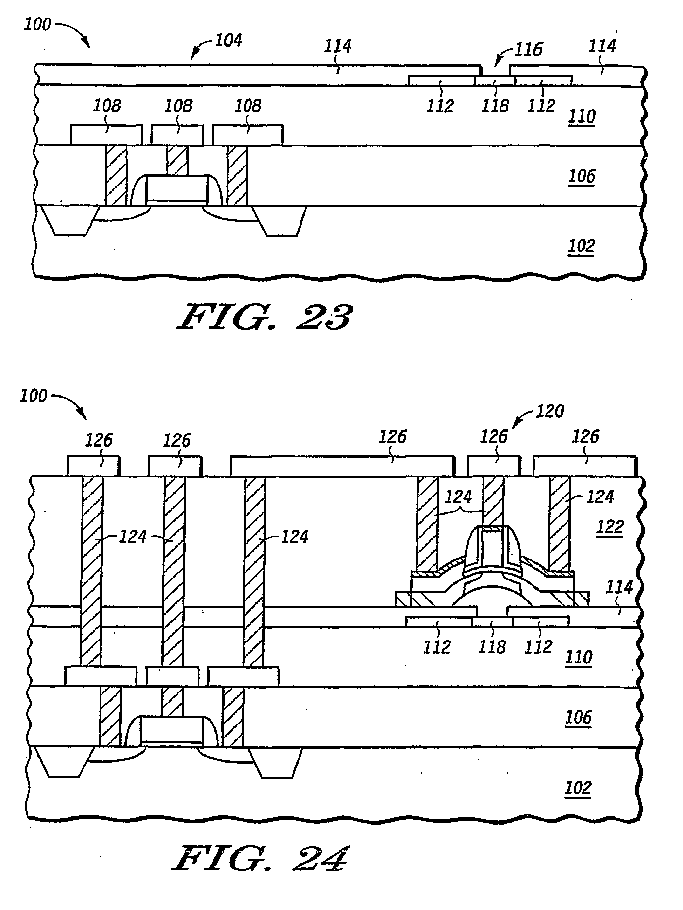

Turning now to Figure 23, in the embodiment wherein semiconductor material 112 includes an amorphous semiconductor material, the portion of material 112 exposed by opening 116 is treated, for example, with laser re-crystallization to form a local region of single crystal semiconductor material. That is, in one embodiment, material 112 includes amorphous silicon and the laser re-crystallization forms a local region of single crystal silicon. Referring now to Figure 24, formation of integrated circuit 100 continues with formation of a strained arch structure semiconductor device 120; using any one of the methods discussed previously herein with reference to one or more of Figures 2-19. Subsequent to formation of the strained arch structure semiconductor device 120, a third interlevel dielectric layer 122, as well as, contact vias 124 and metalizations 126 are formed using standard techniques.

Accordingly, in one embodiment, the forming of the local strain-inducing structure at the point location within the dielectric layer can comprise: forming an opening in the dielectric layer at a first location corresponding to the point location, wherein the opening exposes a portion of the underlying layer of semiconductor material; and forming the local strain-inducing structure (i) over the exposed portion of the underlying layer of semiconductor material or (ii) over the exposed portion of the underlying layer of semiconductor material and a portion of the dielectric layer proximate the opening in the dielectric layer. In addition, in an instance wherein the underlying layer of semiconductor material comprises a poly crystalline layer, then the method further comprises crystallizing the exposed portion of the underlying layer of semiconductor material prior to forming the local strain-inducing structure. Crystallizing the exposed portion of the underlying layer of semiconductor material can comprise the use of laser re-crystallization to form a local region of single crystal semiconductor material.

According to another embodiment, a method of forming a semiconductor device includes forming a local strain-inducing structure of a first semiconductor material at a point location within a dielectric layer. The local strain-inducing structure has a prescribed geometry with a surface disposed above a surface of the dielectric layer. A second semiconductor material is formed over the dielectric layer and the local strain inducing structure, wherein formation of a first portion of the second semiconductor material over the dielectric layer provides a poly crystalline structure of the second semiconductor material and wherein formation of a second portion of the second semiconductor material over the local strain-inducing structure provides a single crystalline structure of the second semiconductor material subject to mechanical strain by the surface of the local strain-inducing structure. The single crystalline structure serves as a strained semiconductor layer of the semiconductor device.

As discussed herein, in one embodiment, forming the local stress-inducing structure comprises forming a nucleation site at the point location and selectively growing the first semiconductor material at the nucleation site. In another embodiment, in forming a plurality of the semiconductor devices, the point location comprises a plurality of point locations that serve as an initial template for locations where local strain-inducing structures and subsequent strained semiconductor layers of the plurality of the semiconductor devices will be formed.

In yet another embodiment, the local strain-inducing structure comprises a seed layer portion of a third semiconductor material and a strain-inducing portion of the first semiconductor material. The seed layer portion is disposed (i) within an opening of the dielectric layer, or (ii) below an opening of the dielectric layer. In addition, the strain-inducing portion is disposed overlying (i) the seed layer portion and (ii) a portion of the dielectric layer proximate the opening in the dielectric layer. Furthermore, the seed layer portion comprises one of amorphous, poly-cyrstalline or single crystalline semiconductor material. Moreover, in one embodiment, the first semiconductor material can comprise Ge or SiGe, the second semiconductor material can comprise Si, and the third semiconductor material can comprise Ge or SiGe.

In a further embodiment, the seed layer portion comprises SiGe having a graded Ge concentration that varies within a range from zero to one-hundred percent (0-100%). In addition, the method further comprises selecting an amount of Ge in the SiGe seed layer portion to provide a desired size of the first semiconductor material at the point location. The size of the first semiconductor material formed over the seed layer portion is determined by the amount of Ge in the SiGe seed layer portion.

In addition, a method of forming a semiconductor device according to another embodiment includes forming a local strain inducing arch structure of a first material and forming a single crystalline region of a second material over the local strain inducing arch structure such that the single crystalline region is subject to mechanical strain by a surface of the strain inducing arch structure. In one embodiment, the first material is selected to have a first lattice constant and the second material is selected to have a second lattice constant different from the first lattice constant. As a result, in addition to the mechanical strain, the second material is further subject to lattice strain when formed over the first material. In another embodiment, the first and second materials are selected such that the first and second lattice constants have a lattice constant mismatch not substantially greater than four percent (4%). ,

In one embodiment, the single crystalline structure is formed so that the surface of the strain inducing structure is an arched surface. The second material is formed on the arched surface of the first material. Furthermore, the arched surface of the first material is formed to have a substantially double-curved surface having first and second orthogonal curvatures, the first and second curvatures being substantially equal and curving towards a dielectric layer or substrate underlying the semiconductor device.

In another embodiment, the strained semiconductor device is a transistor. The single crystalline structure includes a channel of the transistor. The arched surface of the first material is formed to have a substantially double-curved surface having first and second orthogonal curvatures. The first curvature is substantially greater than the second curvature and curving towards a dielectric layer or substrate underlying the semiconductor device. The second curvature is orthogonal to channel current when the device is operational. In addition, the channel is arched over the arched surface of the strain inducing structure.

In yet another embodiment, forming of the single crystalline structure includes growing the single crystalline structure to a thickness selected to facilitate fully depleted operation of the semiconductor device. The single crystalline structure is an active layer of the strained semiconductor device. In addition, a first control electrode structure can be formed over the active layer, the first control electrode structure for controlling current through the active layer when the device is operational. Still further, the method includes replacing, after removing the first semiconductor material and creating a void, the first semiconductor material with a control electrode material to provide a second control electrode structure for controlling current through the active layer when the device is operational. In one embodiment, the first and second control electrode structures are electrically coupled to provide a surround control electrode for controlling current through the active layer when the device is operational. In another embodiment, the first and second control electrode structures provide independent bias controls to independently control current through the active layer when the device is operational.

Furthermore, in yet another embodiment, a transistor includes first and second current handling electrodes and a channel coupled to each of the first and second current handling electrodes, the channel having a non-linear geometry. A gate is disposed proximate to the channel for controlling current flow through the channel between the first and second current handling electrodes. In one embodiment, the channel arches at a portion of the channel electrically between the first and second current handling electrodes. In addition, the channel has a thickness capable of fully depleted operation.

Yet still further, in another embodiment, the first and second current handling electrodes are disposed within a first plane, and the channel comprises a first portion disposed in the first plane proximate to the first current handling electrode, a second portion disposed in the first plane proximate to the second current handling electrode, and a third portion in a second plane parallel to and overlying the first plane. The gate is disposed over the channel and the channel has at least one portion with a curvature characterized by a first derivative which is positive with regard to a reference direction from the gate to the channel. In another embodiment, the transistor comprises multiple gates, with one gate above and one gate below the channel.

Further as disclosed herein, a semiconductor device includes a mechanically strained channel, wherein the channel comprises of a single crystalline structure of a strained semiconductor layer having a non-linear geometry, the non-linear geometry including a portion of an arch shape. The semiconductor device further includes a dielectric layer, wherein a first portion of the channel is disposed overlying a point location within the dielectric layer and a second portion of the channel is disposed overlying a portion of the dielectric layer proximate to and outside of the point location. In addition, a gate is disposed proximate to the channel for controlling current flow through the channel between first and second current handling electrodes that are coupled to the channel.

In the foregoing specification, the disclosure has been described with reference to various embodiments. However, one of ordinary skill in the art appreciates that various modifications and changes can be made without departing from the scope of the present embodiments as set forth in the claims below. Accordingly, the specification and figures are to be regarded in an illustrative rather than a restrictive sense, and all such modifications are intended to be included within the scope of the present embodiments. For example, the semiconductor device can include one or more of a transistor, a diode, an optical device, a light emitting diode, or a laser. An integrated circuit can also be formed using one or more of the methods according to the embodiments herein.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the term "comprises," "comprising," or any other variation thereof, are intended to cover a non-exclusive inclusion, such that a process, method, article, or apparatus that comprises a list of elements does not include only those elements by may include other elements not expressly listed or inherent to such process, method, article, or apparatus.

## Claims

1. A method of forming a semiconductor device (10), comprising:
providing a dielectric layer (14);
forming a local strain-inducing structure (20) of a first semiconductor material at an opening (16, 36) within the dielectric layer (14), the local strain-inducing structure (20) having a prescribed geometry with a surface disposed above a surface of the dielectric layer (14); and
forming a second semiconductor material (22) over the dielectric layer (14) and the local strain inducing structure (20), wherein formation of a first portion (24) of the second semiconductor material (22) over the dielectric layer (14) provides a poly crystalline structure of the second semiconductor material (22) and wherein formation of a second portion (26) of the second semiconductor material (22) over the local strain-inducing structure (20) provides a single crystalline structure of the second semiconductor material (22) subject to mechanical strain by the surface of the local strain-inducing structure (20), the single crystalline structure (26) of the second semiconductor material (22) for use as a strained semiconductor layer of the semiconductor device (10), wherein the prescribed geometry comprises one of (i) a portion of an arched surface, (ii) a portion of a spherical shape, and (iii) a portion of a cylindrical shape with rounded ends; and
removing the first semiconductor material (20) subsequent to forming the single crystalline structure (26), wherein removing the first semiconductor material (20) produces a void (28) under the single crystalline structure (26).

2. The method of claim 1, wherein forming the local stress-inducing structure (20) comprises forming a nucleation site at the opening (16, 36) and selectively growing the first semiconductor material at the nucleation site.

3. The method of claim 1, wherein the opening within the dielectric layer (14) is defined by a length dimension (L) and a width dimension (W), wherein (i) the length dimension is approximately equal to the width dimension or (ii) the length dimension is smaller than the width dimension.

4. The method of claim 1, further comprising:
forming a plurality of the semiconductor devices (10), wherein the opening (16, 36) comprises a plurality of openings that serve as an initial template for locations where local strain-inducing structures (20) and subsequent strained semiconductor layers of the plurality of the semiconductor devices will be formed.

5. The method of claim 1, wherein the local strain-inducing structure (20) comprises a seed layer portion (18) of a third semiconductor material and a strain-inducing portion of the first semiconductor material.

6. The method of claim 5, further wherein the seed layer portion (18) is disposed (i) within an opening (16) of the dielectric layer (14), or (ii) below an opening (16) of the dielectric layer (14), and wherein the strain-inducing portion (20) is disposed overlying (iii) the seed layer portion (18), and (iv) a portion of the dielectric layer (14) proximate the opening (16) in the dielectric layer (14).

7. The method of claim 6, further wherein the seed layer portion (18) comprises one of amorphous, poly-cyrstalline or single crystalline semiconductor material.

8. The method of claim 7, further wherein the seed layer portion (18) comprises SiₓGe₁₋ₓ having a graded Ge concentration wherein x varies within a range from zero to one.

9. The method of claim 8, further comprising selecting an amount of Ge in the SiGe seed layer portion to provide a desired size of the first semiconductor material at the opening (16), wherein the size of the first semiconductor material formed is determined by the amount of Ge in the SiGe seed layer portion.

10. The method of claim 5, wherein the first semiconductor material comprises Ge or SiGe, the second semiconductor material comprises Si, and the third semiconductor material comprises Ge or SiGe.

11. The method of claim 1, further comprising:
selecting the first semiconductor material having a first lattice constant; and
selecting the second semiconductor material having a second lattice constant different from the first lattice constant, wherein the single crystalline structure (26) of the second semiconductor material is further subject to lattice strain in response to being formed over the first semiconductor material.

12. The method of claim 11, further comprising:
selecting the first and second semiconductor materials such that the first and second lattice constants have a lattice constant mismatch not substantially greater than four percent.

13. The method of claim 1, wherein the dielectric layer (14) overlies a substrate (12), and wherein forming of the local strain-inducing structure (20) at the opening (16) within the dielectric layer (14) further comprises:
forming the opening (16) in the dielectric layer (14) at a first location corresponding to the opening (16), wherein the opening (16) exposes a portion of the underlying substrate (12);
forming a semiconductor seed material (18) over the exposed portion of the substrate at the first location; and
forming the local strain-inducing structure (20) (i) over the semiconductor seed material (18) or (ii) over the semiconductor seed material (18) and a portion of the dielectric layer (14) proximate the opening (16) in the dielectric layer (14).

14. The method of claim 13, wherein the semiconductor seed material is selected from the group consisting of silicon, germanium, and silicon germanium and the local strain-inducing structure is selected from the group consisting of silicon, germanium, and silicon germanium.

15. The method of claim 13, wherein the semiconductor seed material and the local strain-inducing structure are each comprised of at least one of group III elements and group V elements.

16. The method of claim 1, wherein the dielectric layer overlies a layer of semiconductor material, and wherein forming of the local strain-inducing structure at the opening (16) within the dielectric layer comprises:
forming the opening (16) in the dielectric layer (14) at a first location corresponding to the opening (16), wherein the opening (16) exposes a portion of the underlying layer of semiconductor material (12); and
forming the local strain-inducing structure (20) (i) over the exposed portion of the underlying layer of semiconductor material (12) or (ii) over the exposed portion of the underlying layer of semiconductor material (12) and a portion of the dielectric layer (14) proximate the opening (16) in the dielectric layer (14).

17. The method of claim 16, wherein the underlying layer of semiconductor material comprises a poly crystalline layer, the method further comprising:
crystallizing the exposed portion of the underlying layer of semiconductor material prior to forming the local strain-inducing structure.

18. The method of claim 17, wherein crystallizing the exposed portion of the underlying layer of semiconductor material comprises the use of laser re-crystallization to form a local region of single crystal semiconductor material.

19. The method of claim 1, wherein the surface of the local strain-inducing structure (20) of the first semiconductor material is an arched surface formed to have a substantially 3D surface having first and second orthogonal curvatures, the first and second curvatures being substantially equal and curving towards the dielectric layer (14).

20. The method of claim 1, wherein the single crystalline structure (26) comprises a channel (38, 82) of a transistor, further wherein the surface of the local strain-inducing structure (20) of the first semiconductor material is an arched surface formed to have a substantially 3D surface having first and second orthogonal curvatures, the first curvature being substantially greater than the second curvature and with both first and second curvatures curving towards the dielectric layer (14), still further wherein the second curvature is orthogonal to a channel current when the transistor is operational.

21. The method of claim 1, further comprising:
refilling the void (28) with a mechanical stress inducing material after removing the first semiconductor material, wherein the presence of the mechanical stress inducing material in the void provides a greater amount of mechanical stress than was provided by the first semiconductor material.

22. The method of claim 1, further comprising:
forming a first control electrode structure over the active layer, the first control electrode structure for controlling current through the active layer when the semiconductor device is operational.

23. The method of claim 1, further comprising:
replacing, after removing the first semiconductor material, the first semiconductor material with a second control electrode structure, the second control electrode structure for controlling current through the active layer when the semiconductor device is operational.

24. The method of claim 23, further comprising:
electrically coupling the first and second control electrode together to provide a surround control electrode for controlling current through the active layer when the semiconductor device is operational; or
leaving the first and second control electrode structures electrically separate to provide independent bias controls for independently controlling current through the active layer when the semiconductor device is operational.

## Patentansprüche

1. Verfahren zur Herstellung eines Halbleiterbauelements (10), das folgendes umfasst:
Bereitstellen einer dielektrischen Schicht (14);
Ausbilden einer lokalen verspannungsinduzierenden Struktur (20) eines ersten Halbleitermaterials an einer Öffnung (16, 36) in der dielektrischen Schicht (14), wobei die lokale verspannungsinduzierende Struktur (20) eine vorgeschriebene Geometrie mit einer Oberfläche, die über einer Oberfläche der dielektrischen Schicht (14) angeordnet ist, aufweist; und
Ausbilden eines zweiten Halbleitermaterials (22) oberhalb der dielektrischen Schicht (14) und der lokalen verspannungsinduzierenden Struktur (20), wobei die Ausbildung eines ersten Teils (24) des zweiten Halbleitermaterials (22) über der dielelektrischen Schicht (14) eine polykristalline Struktur des zweiten Halbleitermaterials (22) ergibt und wobei die Ausbildung eines zweiten Teils (26) des zweiten Halbleitermaterials (22) über der lokalen verspannungsinduzierenden Struktur (20) eine monokristalline Struktur des zweiten Halbleitermaterials (22) ergibt, die einer mechanischen Verspannung durch die Oberfläche der lokalen verspannungsinduzierenden Struktur (20) unterliegt, wobei die monokristalline Struktur (26) des zweiten Halbleitermaterials (22) als verspannte Halbleiterschicht des Halbleiterbauelements (10) dient, wobei die vorgeschriebene Geometrie entweder (i) einen Teil einer bogenförmigen Oberfläche, (ii) einen Teil einer kugelförmigen Form oder (iii) einen Teil einer zylindrischen Form mit gerundeten Enden umfasst; und
Entfernen des ersten Halbleitermaterials (20) im Anschluss an die Ausbildung der monokristallinen Struktur (26), wobei das Entfernen des ersten Halbleitermaterials (20) einen Hohlraum (28) unter der monokristallinen Struktur (26) erzeugt.

2. Verfahren gemäß Anspruch 1, bei dem das Ausbilden der lokalen verspannungsinduzierenden Struktur (20) umfasst, an der Öffnung (16, 36) einen Keimbildungsort zu bilden und das erste Halbleitermaterial selektiv an diesem Keimbildungsort wachsen zu lassen.

3. Verfahren gemäß Anspruch 1, bei dem die Öffnung in der dielektrischen Schicht (14) durch eine Längendimension (L) und eine Breitendimension (B) definiert ist, wobei (i) die Längendimension (L) in etwa gleich der Breitendimension (B) oder (ii) die Längendimension (L) kleiner als die Breitendimension (B) ist.

4. Verfahren gemäß Anspruch 1, das ferner folgendes umfasst:
Herstellen einer Mehrzahl der Halbleiterbauelemente (10), wobei die Öffnung (16, 36) eine Mehrzahl von Öffnungen umfasst, die als Erstschablone für Positionen dienen, an denen lokale verspannungsinduzierende Strukturen (20) und im Anschluss daran verspannte Halbleiterschichten der Mehrzahl der Halbleiterbauelemente (10) ausgebildet werden.

5. Verfahren gemäß Anspruch 1, bei dem die lokale verspannungsinduzierende Struktur (20) einen Keimschichtteil (18) aus einem dritten Halbleitermaterial und einen verspannungsinduzierenden Teil aus dem ersten Halbleitermaterial umfasst.

6. Verfahren gemäß Anspruch 5, bei dem ferner der Keimschichtteil (18) (i) innerhalb einer Öffnung (16) der dielektrischen Schicht (14) oder (ii) unterhalb einer Öffnung (16) der dielektrischen Schicht (14) angeordnet ist und wobei die verspannungsinduzierende Struktur (20) derart angeordnet ist, dass sie (iii) den Keimschichtteil (18) und (iv) einen Teil der dielektrischen Schicht (14) in der Nähe der Öffnung (16) in der dielektrischen Schicht (14) überlagert.

7. Verfahren gemäß Anspruch 6, bei dem ferner der Keimschichtteil (18) ein amorphes, polykristallines oder monokristallines Halbleitermaterial umfasst.

8. Verfahren gemäß Anspruch 7, bei dem ferner der Keimschichtteil (18) SiₓGe₁₋ₓ mit einer abgestuften Germanium (Ge)-Konzentration umfasst, wobei x in einem Bereich von null bis eins variiert.

9. Verfahren gemäß Anspruch 8, bei dem ferner eine Menge von Germanium (Ge) in dem Siliziumgermanium (SiGe)-Keimschichtteil (18) gewählt wird, um eine gewünschte Größe des ersten Halbleitermaterials an der Öffnung (16) bereitzustellen, wobei die ausgebildete Größe des ersten Halbleitermaterials durch die Menge an Germanium (Ge) in dem SiGe-Keimschichtteil (18) bestimmt wird.

10. Verfahren gemäß Anspruch 5, bei dem das erste Halbleitermaterial Germanium (Ge) oder Siliziumgermanium (SiGe) umfasst, das zweite Halbleitermaterial Silizium (Si) umfasst und das dritte Halbleitermaterial Germanium (Ge) oder Siliziumgermanium (SiGe) umfasst.

11. Verfahren gemäß Anspruch 1, das ferner folgendes umfasst:
Auswählen des ersten Halbleitermaterials, das eine erste Gitterkonstante besitzt; und
Auswählen des zweiten Halbleitermaterials (22), das eine zweite Gitterkonstante besitzt, die von der ersten Gitterkonstante verschieden ist, wobei die monokristalline Struktur (26) des zweiten Halbleitermaterials (22) ferner einer Gitterspannung unterliegt, die daraus resultiert, dass sie über dem ersten Halbleitermaterial ausgebildet wird.

12. Verfahren gemäß Anspruch 11, das ferner folgendes umfasst:
Auswählen des ersten und des zweiten Halbleitermaterials, derart, dass die erste und die zweite Gitterkonstante eine Gitterkonstantenabweichung von im Wesentlichen nicht mehr als vier Prozent aufweisen.

13. Verfahren gemäß Anspruch 1, bei dem die dielektrische Schicht (14) über einem Substrat (12) liegt und bei dem das Ausbilden der lokalen verspannungsinduzierenden Struktur (20) an der Öffnung (16) in der dielektrischen Schicht (14) ferner folgendes umfasst:
Ausbilden der Öffnung (16) in der dielektrischen Schicht (14) an einer ersten Position, die der Öffnung (16) entspricht, wobei die Öffnung (16) einen Teil des darunterliegenden Substrats (12) freigibt;
Ausbilden eines Halbleiterkeimmaterials (18) über dem freiliegenden Teil des Substrats an der ersten Position; und
Ausbilden der lokalen verspannungsinduzierenden Struktur (20) (i) über dem Halbleiterkeimmaterial (18) oder (ii) über dem Halbleiterkeimmaterial (18) und einem Teil der dielektrischen Schicht (14) in der Nähe der Öffnung (16) in der dielektrischen Schicht (14).

14. Verfahren gemäß Anspruch 13, bei dem das Halbleiterkeimmaterial aus der Gruppe ausgewählt ist, die aus Silizium, Germanium und Siliziumgermanium besteht, und die lokale verspannungsinduzierende Struktur aus der Gruppe ausgewählt ist, die aus Silizium, Germanium und Siliziumgermanium besteht.

15. Verfahren gemäß Anspruch 13, bei dem das Halbleiterkeimmaterial und die lokale verspannungsinduzierende Struktur jeweils aus mindestens einem der Gruppe-III-Elemente und Gruppe-V-Elemente bestehen.

16. Verfahren gemäß Anspruch 1, bei dem die dielektrische Schicht über einer Schicht aus Halbleitermaterial liegt und bei dem das Ausbilden der lokalen verspannungsinduzierenden Struktur an der Öffnung (16) in der dielektrischen Schicht folgendes umfasst:
Ausbilden der Öffnung (16) in der dielektrischen Schicht (14) an einer ersten Position, die der Öffnung (16) entspricht, wobei die Öffnung (16) einen Teil der darunterliegenden Schicht aus Halbleitermaterial (12) freigibt; und
Ausbilden der lokalen verspannungsinduzierenden Struktur (20) (i) über dem freiliegenden Teil der darunterliegenden Schicht aus Halbleitermaterial (12) oder (ii) über dem freiliegenden Teil der darunterliegenden Schicht aus Halbleitermaterial (12) und einem Teil der dielektrischen Schicht (14) in der Nähe der Öffnung (16) in der dielektrischen Schicht (14).

17. Verfahren gemäß Anspruch 16, bei dem die darunterliegende Schicht aus Halbleitermaterial eine polykristalline Schicht umfasst, wobei das Verfahren ferner folgendes umfasst:
Kristallisieren des freiliegenden Teils der darunterliegenden Schicht aus Halbleitermaterial, bevor die lokale verspannungsinduzierende Struktur ausgebildet wird.

18. Verfahren gemäß Anspruch 17, bei dem das Kristallisieren des freiliegenden Teils der darunterliegenden Schicht aus Halbleitermaterial die Anwendung der Laser-Rekristallisation umfasst, um einen lokalen Bereich aus einem monokristallinen Halbleitermaterial zu bilden.

19. Verfahren gemäß Anspruch 1, bei dem die Oberfläche der lokalen verspannungsinduzierenden Struktur (20) aus dem ersten Halbleitermaterial eine bogenförmige Oberfläche ist, die derart ausgebildet ist, dass sie eine im Wesentlichen dreidimensionale Oberfläche besitzt, welche erste und zweite orthogonale Krümmungen aufweist, wobei die erste und die zweite Krümmung im Wesentlichen gleich und zu der dielektrischen Schicht (14) hin gekrümmt sind.

20. Verfahren gemäß Anspruch 1, bei dem die monokristalline Struktur (26) einen Kanal (38, 82) eines Transistors umfasst, bei dem ferner die Oberfläche der lokalen verspannungsinduzierenden Struktur (20) aus dem ersten Halbleitermaterial eine bogenförmige Oberfläche ist, die derart ausgebildet ist, dass sie eine im Wesentlichen dreidimensionale Oberfläche besitzt, welche erste und zweite orthogonale Krümmungen aufweist, wobei die erste Krümmung im Wesentlichen größer ist als die zweite Krümmung und sich beide Krümmungen zu der dielektrischen Schicht (14) hin krümmen, und bei dem noch ferner die zweite Krümmung orthogonal zu einem Kanalstrom verläuft, wenn der Transistor aktiv ist.

21. Verfahren gemäß Anspruch 1, das ferner folgendes umfasst:
Wiederbefüllung des Hohlraums (28) mit einem Material, das eine mechanische Spannung induziert, nachdem das erste Halbleitermaterial entfernt worden ist, wobei das Vorhandensein des mechanische Spannung induzierenden Materials in dem Hohlraum ein höheres Maß an mechanischer Spannung ergibt als das erste Halbleitermaterial bereitgestellt hat.

22. Verfahren gemäß Anspruch 1, das ferner folgendes umfasst:
Ausbilden einer ersten Kontrollelektrodenstruktur über der aktiven Schicht, wobei die erste Kontrollelektrodenstruktur zum Regeln des Stroms durch die aktive Schicht dient, wenn das Halbleiterbauelement aktiv ist.

23. Verfahren gemäß Anspruch 1, das ferner folgendes umfasst:
nachdem das erste Halbleitermaterial entfernt worden ist, Ersetzen des ersten Halbleitermaterials durch eine zweite Kotrollelektrodenstruktur, wobei die zweite Kontrollelektrodenstruktur zum Regeln des Stroms durch die aktive Schicht dient, wenn das Halbleiterbauelement aktiv ist.

24. Verfahren gemäß Anspruch 23, das ferner folgendes umfasst:
elektrisches Zusammenkoppeln der ersten und der zweiten Kontrollelektrodenstruktur, um eine Rundum-Kontrollelektrode bereitzustellen und den Strom durch die aktive Schicht zu regeln, wenn das Halbleiterbauelement aktiv ist; oder
Elektrische Getrennthaltung der ersten und der zweiten Kontrollelektrodenstruktur, um separate Vorspannungsregler bereitzustellen und den Strom durch die aktive Schicht unabhängig regeln zu können, wenn das Halbleiterbauelement aktiv ist.

## Revendications

1. Procédé de formation d'un dispositif 10 à semiconducteur, dans lequel :
on se procure une couche ( 14 ) diélectrique ;
on forme une structure ( 20 ) locale induisant une contrainte en un premier matériau semiconducteur à une ouverture ( 16, 36 ) au sein de la couche ( 14 ) diélectrique, la structure ( 20 ) locale induisant une contrainte ayant une géométrie prescrite à surface disposée au-dessus d'une surface de la couche ( 14 ) diélectrique ; et
on forme un deuxième matériau ( 22 ) semiconducteur sur la couche (14) diélectrique et sur la structure ( 20 ) locale induisant une contrainte, la formation d'une première partie ( 24 ) du deuxième matériau ( 22 ) semiconducteur sur la couche ( 14 ) diélectrique procurant une structure polycristalline du deuxième matériau ( 22 ) semiconducteur et la formation d'une deuxième partie ( 26 ) du matériau ( 22 ) semiconducteur sur la structure (20) locale induisant une contrainte procurant une structure monocristalline du deuxième matériau (22) semiconducteur soumis à une contrainte mécanique par la surface de la structure ( 20 ) locale induisant une contrainte, la structure ( 26 ) monocristalline du deuxième matériau (22) semiconducteur à utiliser comme couche semiconductrice contrainte du dispositif (10) à semiconducteur, la géométrie prescrite comprenant l'un de ( i ) une partie d'une surface en arche, ( ii ) une partie d'une forme sphérique, et ( iii ) une partie d'une forme cylindrique à extrémité arrondie ; et
on élimine le premier matériau ( 20 ) semiconducteur à la suite de la formation de la structure ( 26 ) monocristalline, l'élimination du premier matériau (20) semiconducteur produisant un vide (28) sous la structure (26) monocristalline.

2. Procédé suivant la revendication 1, dans lequel formée la structure ( 20 ) locale induisant une contrainte, comprend former un site de nucléation à l'ouverture ( 16, 36 ) et faire croître sélectivement le premier matériau semiconducteur au site de nucléation.

3. Procédé suivant la revendication 1, dans lequel l'ouverture au sein de la couche ( 14 ) diélectrique est définie par une dimension ( L ) en longueur et par une dimension ( W ) en largeur, dans lequel ( i ) la dimension en longueur est à peu près égale à la dimension en largeur ou ( ii ) la dimension en longueur est plus petite que la dimension en largeur.

4. Procédé suivant la revendication 1, dans lequel en outre :
on forme une pluralité des dispositifs (10) à semiconducteurs, l'ouverture 16, 36 ) comprenant une pluralité d'ouvertures qui sert de gabarit initial pour des emplacements où des structures (20) locales induisant une contrainte et des couches semiconductrices contraintes subséquentes de la pluralité des dispositifs à semiconducteurs seront formées.

5. Procédé suivant la revendication 1, dans lequel la structure ( 20 ) locale induisant une contrainte comprend une partie ( 18 ) de couche, formant germe, d'un troisième matériau semiconducteur et une partie induisant une contrainte du premier matériau semiconducteur.

6. Procédé suivant la revendication 5, dans lequel en outre, on dispose la partie (18) de couche formant germe, ( i ) dans une ouverture ( 16 ) de la couche ( 14 ) diélectrique ou ( ii ) en-dessous d'une ouverture ( 16 ) de la couche ( 14 ) diélectrique et dans lequel on dispose la partie ( 20 ) induisant une contrainte au-dessus ( iii ) de la partie ( 18 ) de couche formant germe et ( iiii ) d'une partie de la couche ( 14 ) diélectrique proche de l'ouverture (16) dans la couche ( 14 ) diélectrique.

7. Procédé suivant la revendication 6, dans lequel en outre, la partie ( 18 ) de couche formant germe comprend l'un d'un matériau semiconducteur amorphe, polycristallin ou monocristallin.

8. Procédé suivant la revendication 7, dans lequel en outre la partie ( 18 ) de couche formant germe comprend du SiₓGe₁₋ₓ ayant une concentration étagée en Ge, x variant de zéro à un.

9. Procédé suivant la revendication 8, dans lequel en outre on sélectionne une quantité de Ge dans la partie de couche formant germe en SiGe, pour donner une dimension souhaitée du premier matériau semiconducteur à l'ouverture ( 16 ), la dimension du premier matériau semiconducteur formée étant déterminée par la quantité de Ge par la partie de couche formant germe en SiGe.

10. Procédé suivant la revendication 5, dans lequel le premier matériau semiconducteur comprend du Ge ou du SiGe, le deuxième matériau semiconducteur comprend du Si, et le troisième matériau semiconducteur comprend du Ge ou du SiGe.

11. Procédé suivant la revendication 1, dans lequel en outre :
on sélectionne le premier matériau semiconducteur ayant une première constante de réseau ; et
on sélectionne le deuxième matériau semiconducteur ayant une deuxième constante de réseau différente de la première constante de réseau, la structure ( 26 ) monocristalline du deuxième matériau semiconducteur étant soumise en outre à une contrainte de réseau en réaction à sa formation sur le premier matériau semiconducteur.

12. Procédé suivant la revendication 1, dans lequel en outre :
on sélectionne le premier et le deuxième matériaux semiconducteur, de manière à ce que la première et la deuxième constantes de réseau aient un défaut de concordance de constante de réseau qui ne soit pas sensiblement plus grand que quatre pourcent.

13. Procédé suivant la revendication 1, dans lequel la couche ( 14 ) diélectrique est au-dessus d'un substrat ( 12 ), et dans lequel former la structure ( 20 ) locale induisant une contrainte à l'ouverture ( 16 ) au sein de la couche ( 14 ) diélectrique, comprend en outre :
former l'ouverture (16) dans la couche (14) diélectrique en un premier endroit correspondant à l'ouverture ( 16 ), l'ouverture ( 16 ) mettant à découvert une partie du substrat ( 12 ) sous-jacent ;
former un matériau (18) semiconducteur formant germe sur la partie à découvert du substrat en le premier endroit ; et
former la structure (20) locale induisant une contrainte ( i ) sur le matériau ( 18 ) semiconducteur formant germe ou ( ii ) sur le matériau ( 18 ) semiconducteur formant germe et sur une partie de la couche ( 14 ) diélectrique proche de l'ouverture (16) dans la couche (14) diélectrique.

14. Procédé suivant la revendication 13, dans le lequel on choisit le matériau semiconducteur formant germe dans le groupe consistant en le silicium, le germanium, et le silicium germanium et on choisit la structure locale induisant une contrainte dans le groupe consistant en le silicium, le germanium et le silicium germanium.

15. Procédé suivant la revendication 13, dans lequel le matériau semiconducteur formant germe et la structure locale induisant une contrainte comprennent chacun au moins l'un des éléments du groupe III et des éléments du groupe V.

16. Procédé suivant la revendication 1, dans lequel la couche diélectrique est au-dessus d'une couche de matériau semiconducteur et dans lequel former la structure locale induisant une contrainte à l'ouverture ( 16 ) au sein de la couche diélectrique comprend :
former l'ouverture (16) dans la couche ( 14 ) diélectrique en un premier endroit correspondant à l'ouverture ( 16 ), l'ouverture ( 16 ) mettant à découvert une partie de la couche sous-jacente du matériau ( 12 ) semiconducteur ; et
former la structure (20) locale induisant une contrainte ( i ) sur la partie à découvert de la couche sous-jacente du matériau ( 12 ) semiconducteur ou ( ii ) sur la partie à découvert de la couche sous-jacente du matériau semiconducteur et sur une partie de la couche ( 14 ) diélectrique proche de l'ouverture (16) dans la couche ( 14 ) diélectrique.

17. Procédé suivant la revendication 16, dans lequel la couche sous-jacente du matériau semiconducteur comprend une couche polycristalline, le procédé comprenant en outre le fait de :
faire cristalliser la partie à découvert de la couche sous-jacente du matériau semiconducteur avant de former la structure locale induisant une contrainte.

18. Procédé suivant la revendication 17, dans lequel faire cristalliser la partie à découvert de la couche sous-jacente de matériau semiconducteur comprend l'utilisation d'une recristallisation par laser pour former une région locale de matériau semiconducteur ou monocristallin.

19. Procédé suivant la revendication 1, dans lequel la surface de la structure ( 20 ) locale induisant une contrainte du premier matériau semiconducteur est une surface en arche formée de manière à avoir une surface sensiblement en 3D ayant des première et deuxième courbures orthogonales, les première et deuxième courbures orthogonales étant sensiblement égales et se courbant vers la couche ( 14 ) diélectrique.

20. Procédé suivant la revendication 1, dans lequel la structure ( 26 ) monocristalline comprend un canal ( 38, 82 ) d'un transistor, dans lequel en outre la surface de la structure ( 20 ) locale induisant une contrainte du premier matériau semiconducteur est une surface en arche formée pour avoir une surface sensiblement en 3D, ayant des première et deuxième courbures orthogonales, la première courbure étant sensiblement plus grande que la deuxième courbure et les deux première et deuxième courbures se courbant vers la couche ( 14 ) diélectrique, dans lequel en outre la deuxième courbure est orthogonale à un courant de canal, lorsque que le transistor est en fonctionnement.

21. Procédé suivant la revendication 1, dans lequel en outre :
on remplit le vide (28) d'un matériau induisant une contrainte mécanique après avoir éliminé le premier matériau semiconducteur, la présence du matériau induisant une contrainte mécanique dans le vide procurant davantage de contrainte mécanique que ce qui était procuré par le premier matériau semiconducteur.

22. Procédé suivant la revendication 1, dans lequel en outre :
on forme une première structure d'électrode de commande sur la couche active, la première structure d'électrode de commande étant destinée à commander le courant passant dans la couche active, lorsque le dispositif à semiconducteur est en fonctionnement.

23. Procédé suivant la revendication 1, dans lequel en outre :
on remplace, après avoir éliminé le premier matériau semiconducteur, le premier matériau semiconducteur par une deuxième structure d'électrode de commande, la deuxième structure d'électrode de commande étant destinée à commander le courant passant dans la couche active, lorsque le dispositif à semiconducteur est en fonctionnement.

24. Procédé suivant la revendication 23, dans lequel en outre :
on couple électriquement la première et la deuxième électrodes de commande ensemble, pour obtenir une électrode de commande entourante afin de commander le courant qui passe dans la couche active, lorsque le dispositif à semiconducteur est en fonctionnement ; ou
on laisse les première et deuxième structures d'électrode de commande, séparées électriquement, pour obtenir des commandes polarisées indépendantes pour commander indépendamment le courant qui passe dans la couche active, lorsque le dispositif à semiconducteur est en fonctionnement.
